# EUROPEAN PATENT APPLICATION

(11) **EP 2 182 505 A1**
(43) Date of publication of application: **05.05.2010**
(21) Application number: 09015971.6
(22) Date of filing: 17.01.2007
(51) Int. Cl.: G09G 3/28

(54) **Plasma display apparatus**

(30) Priority: 09.03.2006 JP 2006063665
(62) Divisional of application: 07000891.7
(71) Applicant: HITACHI, LTD., Chiyoda-ku Tokyo 100-8280 (JP); Advanced PDP Development Center Corporation, Bunkyo-ku Tokyo (JP)
(72) Inventor: Mori, Mutsuhiro, Chiyoda-ku Tokyo 100-8220 (JP)
(74) Representative: Beetz & Partner

(57) **Abstract**

The present invention relates to a plasma display apparatus, comprising a plasma display (8) ; a light emitting discharge circuit (401) having a semiconductor device which drives electrodes of the plasma display (8); and a power collector circuit (402) for collecting a charge current and a discharge current of the plasma display, having a reverse blocking IGBT (300). The reverse blocking IGBT (300) includes a first semiconductor layer (218, 210) of a first conductive type (p); a first main electrode (252) formed on one surface of the first semiconductor layer (218); a second semiconductor layer (211) of second conductive type (n) formed to be connected to the first semiconductor layer (210) ; a second main electrode (250) formed on the second semiconductor layer (211) opposite to the first main electrode (252); an insulated gate electrode (254) which controls a current flowing from the first main electrode (252) to the second main electrode (250); and a diode region, formed in the first and second semiconductor layers (210, 211), to prevent a current flowing in a reverse direction to the current flowing from the first main electrode (252) to the second main electrode (250).

## Description

### BACKGROUND OF THE INVENTION

The present invention relates to allowing a plasma display apparatus to have the economy of electric power and the low cost, and in particular, to a plasma display apparatus appropriate for allowing its driving circuit to have the low loss and for the reduction of the number of the parts.

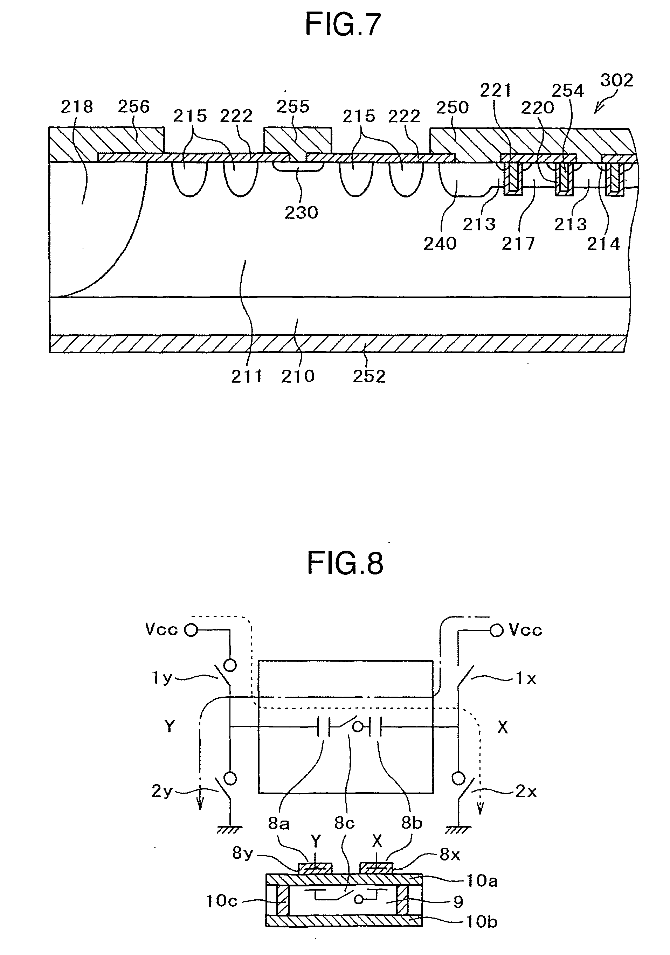

Recently, the plasma display apparatus has rapidly become popular because it has a larger screen and also it is thinner as compared with a conventional cathode-lay tube television, etc., but it has problems that its current consumption is large because of its large screen and its cost is high. FIG. 8 is a conceptual diagram showing a pixel structure and its operation of the plasma display apparatus. A front glass 10a and a back glass 10b are spaced by a rib 10c and light emitting gas 9 such as Xe, etc. is encapsulated. On the front glass 10a an electrode Y 8a and an electrode X 8b are formed and when a voltage is applied to the electrode Y 8a and the electrode X 8b, a charge is produced on the opposite surface to the front glass 10a with which these electrodes contact, and when the potential difference of the charge becomes equal to or larger than the discharge voltage, the light is emitted. Namely, speaking in the case of an electrical circuit, a switch 8c is turned on and it comes into the discharged state. To realize this, switches 1x, 2x, 1y, 2y are used as external circuits. First, 1x and 2y are turned on, next, 1y and 2x are turned on, and these operations are alternately repeated. The light is emitted every time these switches are turned on and by increasing the number of times of alternate repetition the brightness of the plasma display apparatus can be increased.

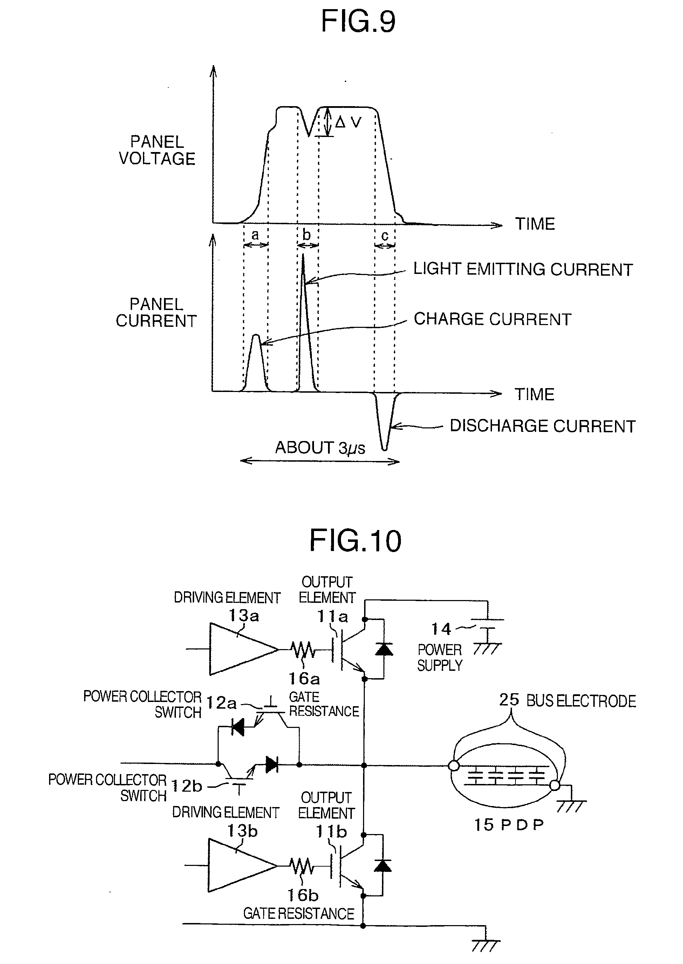

FIG. 9 shows a change by time of a panel voltage and a panel current between X and Y when the light is emitted. When the panel voltage is applied in a period a, first, a charge current to charge the capacity of the front glass and XY wiring, etc. flows. When the panel voltage becomes higher than the discharge starting voltage, a steep light emitting current flows in a period b. At this time, the panel voltage drops by ΔV because of the inductance of the wiring of X and Y, etc. Next, when the panel voltage is removed, the charge which has been stored in the capacity of the front glass and the XY wiring, etc. is discharged in a period c. This period is as short as about 3 µs and is repeated at a fast speed of from a few 10 kHz to a few 100 kHz. At this time, a loss is produced at each switch by the charge current, the light emitting current, and the discharge current which pass the switches 1x, 2x, 1y, and 2y, and the loss becomes one of the causes to increase the power consumption of the plasma display apparatus.

FIG. 10 shows a driving circuit of a plasma display apparatus shown in patent document 1 (JP-A-2000-330514). In comparison with the circuit of FIG. 8, it is characterized in that power collector switches 12a, 12b which collect the charge current and the discharge current are newly added and IGBT (Insulated Gate Bipolar Transistor) is used for these switching elements. By using IGBT, as compared with a conventional power MOSFET, a conductivity modulation is produced within the device and the resistance becomes smaller and the power dissipation can be reduced. In the apparatus of the above-mentioned patent document 1, as a typical IGBT does not have a diode built-in, the diodes are provided other than output elements 11a, 11b, and power collector switches 12a, 12b. Thereby, the number of the parts increased, the circuit and the assembly processing became complicated, and the cost became higher.

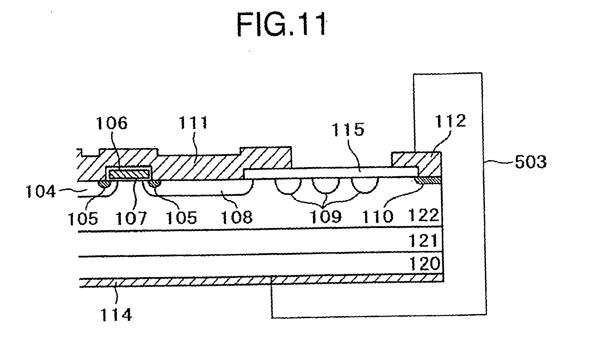

FIG. 11 is not a plasma display apparatus, but it is IGBT which has a diode built-in used for an igniter of a car shown in a patent document 2 (JP-A-9-199712). When a reverse voltage is applied to IGBT by a voltage vibration by an ignition coil, the reverse voltage is avoided by diodes provided on the periphery of the IGBT chip. The diodes are formed between a p layer 108 and an n layer 110 and they are formed so that a forward voltage VF produced by a current flowing between these p and n becomes smaller than a reverse blocking voltage between a p layer 120 and an n layer 121. However, as the switching of the igniter corresponds to a few thousands rpm which is the rotational speed of engine it is slow, consequently, the operation of this built-in diode is also slow, therefore it was not suited for the use for the plasma display apparatus. That is, the loss at the time of switching is large and it is not appropriate for the fast speed operation of the plasma display apparatus.

In JP-A-2000-307116 an example of a structure of trench insulated-gate type IGBT is disclosed.

### SUMMARY OF THE INVENTION

An object of the present invention is to solve the above-mentioned problems of the prior art, and in particular, by applying an IGBT which has a diode built-in, to realize the economy of the power and the low cost of the plasma display apparatus, and in particular, to provide a plasma display apparatus appropriate for the low loss of its driving circuit and the reduction of the number of the parts.

This object is accomplished with a plasma display apparatus according to claim 1.

Dependent claims are directed on features of preferred embodiments of the invention.

According to the present invention, by mounting IGBT which has a built-in diode which is reverse conducting to the driving device which supplies a light emitting current and IGBT which has a built-in diode which has a reverse blocking function to the driving device which collects and charges the power, it is possible to reduce the number of the parts of the plasma display apparatus and to reduce the cost of the assembly processing, and by mounting and controlling a diode appropriate for the plasma display apparatus, it is possible to reduce the loss and to reduce the power consumption.

Other objects, features and advantages of the invention will become apparent from the following description of the embodiments of the invention taken in conjunction with the accompanying drawings.

### BRIEF DESCRIPTION OF THE DRAWINGS

FIG. 1 is a diagram showing an embodiment of a plasma display apparatus of the present invention.
FIG. 2 is a diagram showing an embodiment of IGBT having a reverse conducting diode built-in of the present invention.
FIG. 3 is a diagram showing another embodiment of the IGBT having a reverse conducting diode built-in of the present invention.
FIG. 4 is a diagram showing further other embodiment of the IGBT having a reverse conducting diode built-in of the present invention.
FIG. 5 is a diagram showing an embodiment of IGBT having a reverse blocking diode built-in of the present invention.
FIG. 6 is a diagram showing another embodiment of the IGBT having a reverse blocking diode built-in of the present invention.
FIG. 7 is a diagram showing further other embodiment of the IGBT having a reverse blocking diode built-in of the present invention.
FIG. 8 is a diagram showing a schematic cross section diagram of a cell of an AC type PDP and its driving.
FIG. 9 is a diagram showing a driving waveform of the AC type PDP.
FIG. 10 is a diagram showing a driving circuit of a conventional plasma display apparatus.
FIG. 11 is a diagram showing a conventional example of IGBT having a reverse conducting diode built-in.

### DESCRIPTION OF THE EMBODIMENTS

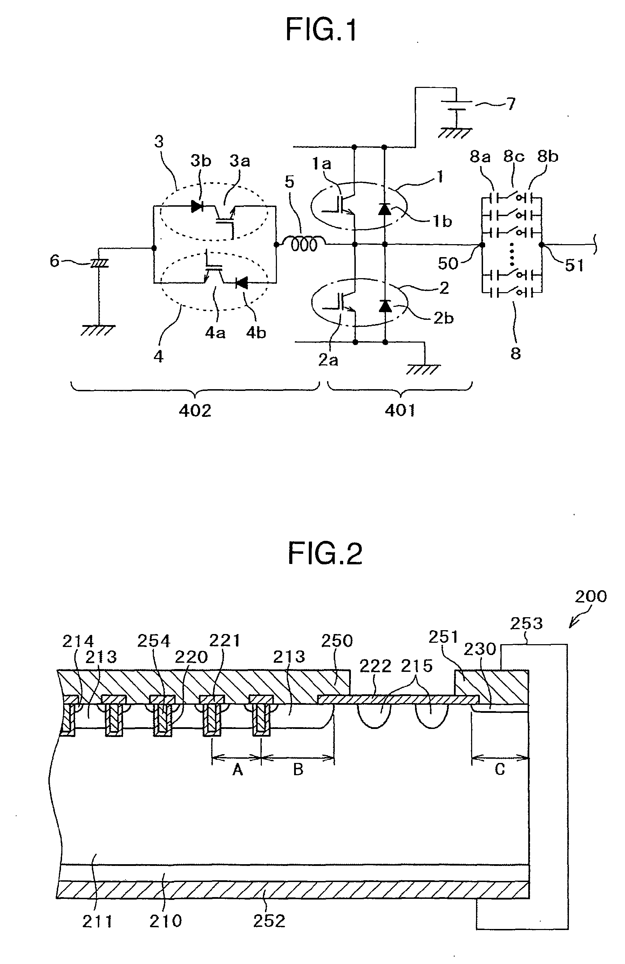

The details of the present invention will be explained below using the figures of the embodiments. FIG. 1 is a diagram showing an embodiment of a plasma display apparatus of the present invention. An equivalent circuit of a plasma panel is denoted by 8. IGBTs 1, 2 having reverse conducting diodes built-in (hereinafter, they are shortened to reverse conducting IGBTs) are connected in series to a power supply 7 forming a circuit configuration of a totem pole scheme. A connection point 50 (a central point 50) is connected to the equivalent circuit 8 and supplies power mainly when the light is emitted. Namely, when the reverse conducting IGBT 1 is turned on, a positive potential is applied to the equivalent circuit 8 and the light is emitted. Afterward, the energy stored in capacities of the plasma panel 8a, 8b is collected to a capacitor 6 by a resonance current of a coil 5 and the capacities 8a, 8b by turning IGBT 4 having a reverse blocking diode 4b built-in (hereinafter, it is shortened to a reverse blocking IGBT) on. When the central point 50 of the reverse conducting IGBT lowers to the potential as low as close to the ground potential, the reverse conducting IGBT is turned on and the central point 50 is fixed to the ground potential. At this time, by maintaining the gate voltage of the reverse blocking IGBT 4 in the on state until the reverse conducting IGBT becomes sufficiently on, the charge in the reverse blocking IGBT 4 can be spilled out at a fast speed and the switching loss can be reduced. Next, when the potential is applied to the plasma panel 8 again, first, a reverse blocking IGBT 3 is turned on and the energy stored in the capacitor 6 is supplied to the plasma panel 8 using the coil 5. When the central point 50 rises to close to the potential of the power supply 7 by the resonance, the reverse conducting IGBT 1 is turned on, the plasma panel & is raised to the potential of the power supply 7 and the light is emitted again. Also when the reverse conducting IGBT 1 is turned on, by maintaining the gate of the reverse blocking IGBT 3 in the on state until the reverse conducting IGBT 1 becomes sufficiently on, the charge in the reverse blocking IGBT 3 can be spilled out at a fast speed and the switching loss can be reduced. Here, from the above operation principle, a circuit consisting of the power supply 7 and the reverse conducting IGBTs 1, 2 will be called a light emitting discharge circuit 401, and a circuit consisting of the coil 5, the capacitor 6, and the reverse blocking IGBTs 3, 4 will be called a power collector circuit 402. The light emitting discharge circuit 401 and the power collector circuit 402 are provided also on the opposite side of the plasma panel 8 and connected to a central point 51, and similarly operate.

Now, in the plasma display apparatus of FIG. 1, a circuit area connected between the high potential side connected to the power supply 7 and the central point 50 connected to the plasma panel is hereinafter called "an upper arm", and a circuit area connected between the low potential side connected to the ground potential and the central point 50 connected to the plasma panel is hereinafter called "a lower arm".

Here, when the capacitor 6 or the panel capacities 8a, 8b and the coil 5 resonate, the diode 1b of the reverse conducting IGBT 1 protects the central point 50 so that it will not have a voltage equal to or greater than the power supply 7. If the central point 50 has an overvoltage, the overvoltage is applied to the plasma panel 8 and in the worst case the panel will be destroyed. However, it has been found that the current which flows to this diode 1b is as small as equal to or less than 1/10 to the current which flows to IGBT 1a, and a diode with a small current capacity is sufficient. Then, the details will be described below, it has been found that by integrating it on the outer periphery of the chip of the IGBT 1a, it sufficiently serves as diode 1b of the plasma panel. However, it has been found that as the plasma panel switches at the fast speed as from a few 10 kHz to a few 100 kHz, the current capacity of the diode 1b needs to be fast although it is small, and it is preferable to reduce the lifetime of the minority carrier by the electron beam radiation, etc. In this case, it has been found that the lifetime needs to be reduced at the maximum equal to or less than 1 µs.

On the other hand, the current flows to the diode 2b of the reverse conducting IGBT 2 when the reverse blocking IGBT 4 connected to the side of the central point 51 is turned on. Therefore, to the diode 2b, a large current of a few 10A equivalent to that of the reverse blocking IGBT 4 flows. Consequently, it has been found that although the reverse conducting IGBTs 1, 2 are the same, they may be the reverse conducting IGBTs whose diodes have totally different current capacities. Hence, it also will be described below, when the diode 2b is provided on the outer periphery of the IGBT chip, it is preferable to form the diodes allover the outer periphery of the chip. Also, as the plasma panel switches at a speed as fast as from a few 10 kHz to a few 100 kHz, it is necessary to reduce the lifetime of the minority carrier of the diode 2b of the reverse conducting IGBT 2 so that the charge inside of the diode 2b of the reverse conducting IGBT 2 will disappear before the reverse conducting IGBT 1 is turned on. It has been found that if the lifetime of the diode 2b is long and the charge remains, when the reverse conducting IGBT 1 is turned on, because the current from the power supply 7 passes through the reverse conducting IGBTs 1, 2 and makes a short cut current flow, an extremely large loss will be produced.

In the power collector switches 12a, 12b shown in FIG. 10 the diodes are simply connected to the IGBTs in series. Therefore, there was a problem that when a current flows to the power collector switches 12a, 12b, a diffusion potential of about 1V which forward biases a pn junction of the diode and a diffusion potential of about 1V which forward biases a pn junction which is on the side of the collector of the IGBT occur doubly, and a large power dissipation is produced and the power collector efficiency deteriorates. The reverse blocking IGBTs 3, 4 of the present invention serve both as a pn junction of the diodes (3b, 4b) and a pn junction of the IGBTs 3a, 4a. Therefore, the pn junction which conventionally was dual becomes one and there is no drop of the voltage and the power collector efficiency is greatly improved. The power collector efficiency which was conventionally about 75% becomes 85%. It has been found that with the power collector efficiency improved, as the central points 50, 51 can be made to be close to the potential of the power supply 7 or the ground potential, the reverse bias applied to the diodes (3b, 4b) becomes smaller and the noise is not likely to occur. In order to further reduce the noise, it is preferable that the lifetime of the minority carrier of the reverse blocking IGBTs 3, 4 also should be reduced by the electron beam radiation, etc. It has been found that by reducing the lifetime equal to or less than 1 µs the power collector efficiency is further improved.

As described above, by using the reverse conducting IGBTs 1,2 and the reverse blocking IGBTs 3, 4 for the plasma display apparatus, as compared with the case where the conventional IGBT and diode are separately used, the number of the parts can be reduced to the half and the assembly processing becomes simpler. Further, by having the diode built-in, the loss can be reduced and the power collector efficiency can be improved. Further, as a result of that the power distribution dedicated to the diode becomes unnecessary, the wiring becomes shorter, the noise caused by the inductance of the wiring becomes smaller, and a driving circuit which is easy to handle can be realized. Moreover, by reducing the lifetime of the reverse conducting IGBTs 1, 2 and the reverse blocking IGBTs 3, 4, there are advantages that the high frequency driving becomes possible, the brightness of the plasma display apparatus can be enhanced, and the gradation can be fine.

FIG. 2 shows an embodiment applicable to the reverse conducting IGBTs 1, 2 of FIG. 1. A reverse conducting IGBT 200 is consisted of a p layer 213 diffused in a n- layer 211 contacting with a p layer 210 and a n+ layer 214 formed in the p layer 213, and with the p layer 210 a collector electrode 252 contacts with low resistance. The p layer 210 may be formed by diffusing the p layer 210 on the n- substrate 211 formed by the FZ method, or it may be formed by crystal growing an epitaxial layer of n- layer on the p+ substrate 210. A gate electrode 254 of trench form is formed so that it contacts with the n+ layer 214, the p layer 213, and the n- layer 211 via an insulated gate 220. On the outer periphery of the reverse conducting IGBT 200 an n+ layer 230 which becomes a channel stopper layer which retrains the extension of the depletion layer in a termination region is formed, and with this n+ layer 230 a cathode electrode 251 contacts with low resistance. Between the n+ layer 230 and the p layer 213 close to it, a FLR (Field Limiting Ring) consisting of a p layer 215 is formed and assures the blocking voltage of the reverse conducting IGBT 200. The cathode electrode 251 can be electrically connected to the collector electrode 252 with low resistance by an electrical connecting wiring 253 and the reverse conducting diode can be built in the IGBT between the p layer 213 and the n+ layer 230. The connecting method includes the connections by wire bonding or solder, etc.

Generally, for IGBT there is a planar gate structure which forms the insulated gate on the silicon surface evenly other than the gate structure of trench gate type shown in this embodiment, but as a result of the consideration, it has been found that the IGBT of the trench gate structure has a lower loss.

The reason is because it has been found that as the plasma display apparatus makes a steep current flow to the capacity load, IGBT which has greater saturation current density, namely whose insulated gate is dense per unit area, is preferable. As a result, it is preferable that a space A between each of the trench type insulated gates 220 and 254 should be smaller and the p layer 213 formed between them becomes narrow. On the other hand, for the reverse conducting diode, it is necessary to enlarge a width B of the p layer 213 on the most outer periphery because it is necessary to make a current flow, and it has been found that it is preferable to make the size of the width B at least greater than A in order to avoid that the movement of the charge by the operation of the diode would effect under the insulated gate. Also, it has been found that even if the size of the width B becomes larger than necessary, the forward voltage of the diode would not be reduced, and the size of the width B is sufficient if it is equal to or less than the twice of the thickness of the n- layer 211. Also, a width C of the n+ layer 230, similarly to the width B, is needed to be wider than A, and is preferably equal to the width B.

In order to make the reverse conducting IGBT 200 fast, it is only needed to make the lifetime of the minority carrier short, for example, by radiating the overall reverse conducting IGBT 200 with the electron beam. Thereby, it is possible to make not only the IGBT region but also the diode region fast at the same time, and it is possible to realize easily the reverse conducting IGBT 200 which resists the high frequency operation.

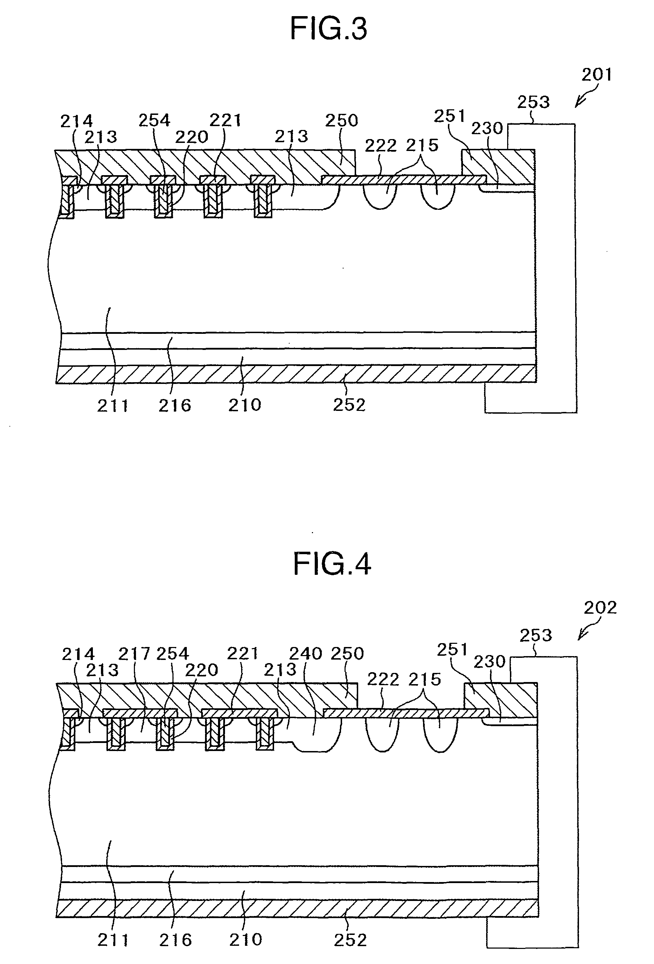

FIG. 3 is characterized in that an n layer 216 is provided between the p layer 210 and the n-layer 211. By providing the n layer 216, it is possible to make the n- layer 211 thinner as compared with FIG. 1, to lead the electron current injected from the n+ layer 230 to the p layer 213 via the n layer 216 which has a lower resistance than the n- layer 211, to make the forward voltage of the diode of a reverse conducting IGBT 201 smaller, and as a result, to make the loss smaller. As the n layer 216 is higher in impurity concentration by not less than about 2 digits than the n- layer 211 the effect of the reduction of the lifetime by the electron beam is also greater, the faster reverse conducting IGBT 201 can be obtained, and it is a more appropriate structure for the high brightness and high gradation of the plasma display apparatus. Also in the IGBT region comprising the trench gate, as the n- layer 211 is thin the conductivity modulation occurs rapidly, it is possible to make the light emitting current flow with low loss, and also it can.be cut off at a fast speed fortunately also because the lifetime of the n layer 216 is short.

FIG. 4 is the other embodiment of a reverse conducting IGBT 202. It is characterized in that a p layer 217 which is floating is alternately provided between the trench gates. The inventors of the present invention have found that by providing this floating p layer 217 it is possible to further facilitate the conductivity modulation of the IGBT of the trench gate structure in another invention which is a patent document 3 (JP-A-2000-307116), and they have found that this structure is effective also in the plasma display apparatus which is capacity loaded, and the reverse conducting diode also can be built in. Also, to a p layer 240 forming the diode, the p layer 240 which is deeper than the p layer 213 is formed.

In order to reduce the forward voltage of the pn diode, it is effective to shorten the distance between the p layer 240 which has an FLR 215 and the n+ layer 230. For this purpose, it has been found that it is effective to deepen the depth of the p layer 240 and the FLR 215 because the electric field can be alleviated. Further, it has also been found that by reducing the injection of the hole by making the p layer 240 deep and the tilt of the impurity concentration soft, the lateral pn diode recovers softly and the noise becomes lower.

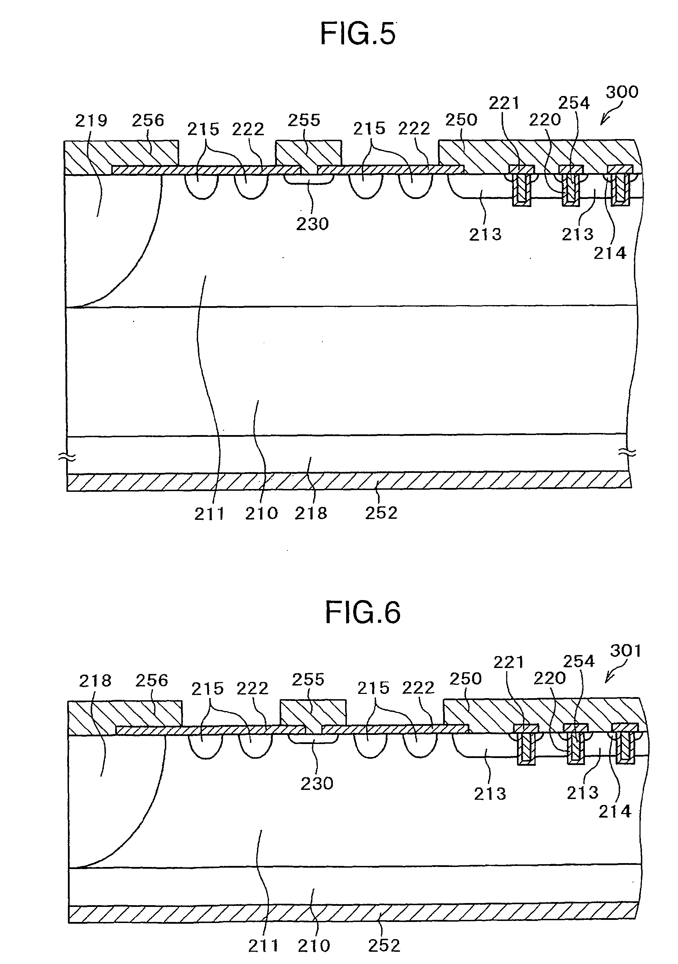

FIG. 5 shows an embodiment of the reverse blocking IGBT 3, 4 of the power collector circuit 402. A reverse blocking IGBT 300 is consisted of the p+ layer 210 formed contacting with the p+ substrate 218, a p layer 219 extending into the n- layer 211 on the outer periphery of the chip, an anode electrode 256 contacting with the p layer 219 with low resistance, and a cathode electrode 255 contacting with the n+ layer 230 with low resistance, etc. In the IGBT region a trench type gate insulated film 220 and a gate electrode 254 are formed. Between the p layer 213, the p layer 219 and the n+ layer 215 a pn diode connected backward is formed, and the FLR 215 which consists of the p layer may be formed depending on the necessary blocking voltage. On the operation the cathode electrode 255 and the anode electrode 256 are unnecessary, but by extending an emitter electrode 250, the cathode electrode 255, and an anode electrode 256 until over the n- layer 211 via an insulating film 222 it is possible to make it have a high blocking voltage easily. In this reverse blocking IGBT 300, the forward blocking voltage is mainly achieved between the p layer 213 and the n- layer 211. On the other hand, the reverse blocking voltage is mainly secured between the p+ layer 210, the p layer 219 and the n- layer 211. As a result, the diode of the power collector switch shown in FIG. 10 becomes unnecessary and the forward voltage of the amount for one diode is reduced from the power collector circuit 402, and it is possible to realize the low loss, high effectiveness of the power collector circuit 402.

Here, the manufacturing method for the reverse blocking IGBT 300 will be described. First, on the p+ substrate 218, an n- epitaxial layer with a thickness corresponding to the thickness of the 210 layer and the 211 layer added is formed. Next, the p layer 219 is formed by introducing it by ion injection, etc. from the side of the anode electrode 256 and diffusing it. At this time, p type impurity is diffused from the p+ substrate 210 at the same time, forms the p layer 210, and contacts with the p layer 219. Further, trench gate structure 220, 254, the p layers 213, 215, and the n+ layer 214 are formed, and each kind of the electrodes 252, 250, 255, and 256 are formed and the IGBT is completed. As it has been described referring to FIG. 1, also with this reverse blocking IGBT 300 when the lifetime of the minority carrier is shortened by the electron beam radiation, etc., it is possible to obtain the high brightness and high gradation of the plasma display apparatus.

While a voltage equivalent to the voltage of the power supply 7 is always applied to the reverse conducting IGBTs 1, 2 shown in FIG. 1, only about half of the voltage of the power supply 7 is applied to the reverse blocking IGBTs 3, 4 because the coil 5 and the capacitor 6 maintain the voltage. Therefore, the thickness of the n- layer of the reverse blocking IGBTs 3, 4 is preferably thinner as compared with the thickness of the n- layer 211 of the reverse conducting IGBTs 1, 2.

FIG. 6 shows an embodiment of the other reverse blocking IGBT. In the case of a reverse blocking IGBT 301, first, a p layer 218 is formed using silicon crystal of the n- 211 formed by the FZ method. The trench gate structure 220, 254, the p layers 213, 215, and the n+ layer 214 are formed, the electrodes 250, 255, 256 are formed, the p+ layer 210 is formed after making the silicon crystal of the n- 211 as thin as a desired thickness, and the collector electrode 252 is formed. Thereby, the reverse blocking IGBT 301 can be formed without using the n- layer 211 formed by expensive epitaxial, the cost reduction of the plasma display apparatus becomes possible. Also, there are advantages that the total thickness of the semiconductor layers becomes thinner, the thermal resistance becomes smaller, and the cooling becomes simpler.

FIG. 7 is the other embodiment of the reverse blocking IGBT. Similarly to FIG. 4, a p layer of floating 217 and a deep p layer 215 are formed, and in the same way as described referring to FIG. 4, it has an effect that it is possible to facilitate the conductivity modulation and make the reverse blocking IGBT 302 have a low loss, and an effect that the high blocking voltage can be formed with a termination of short distance and make the reverse blocking IGBT 302 miniaturized and with low cost.

According to the present invention it is possible to reduce the number of the parts of the plasma display apparatus, to reduce the number of the steps of the assembly processing, to reduce the loss of the driving circuit of the plasma display apparatus, and to realize a plasma display apparatus with small power consumption and low cost.

It should be further understood by those skilled in the art that although the foregoing description has been made on embodiments of the invention, the invention is not limited thereto and various changes and modifications may be made without departing from the spirit of the invention and the scope of the appended claims.

## Claims

1. A plasma display apparatus, comprising:
a plasma display (8);
a light emitting discharge circuit (401) having a semiconductor device which drives electrodes of the plasma display (8); and
a power collector circuit (402) for collecting a charge current and a discharge current of the plasma display, having a reverse blocking IGBT (300), wherein the reverse blocking IGBT (300) includes
a first semiconductor layer (218, 210) of a first conductive type (p);
a first main electrode (252) formed on one surface of the first semiconductor layer (218);
a second semiconductor layer (211) of second conductive type (n) formed to be connected to the first semiconductor layer (210);
a second main electrode (250) formed on the second semiconductor layer (211) opposite to the first main electrode (252);
an insulated gate electrode (254) which controls a current flowing from the first main electrode (252) to the second main electrode (250); and
a diode region, formed in the first and second semiconductor layers (210, 211), to prevent a current flowing in a reverse direction to the current flowing from the first main electrode (252) to the second main electrode (250).

2. The plasma display apparatus according to claim 1, wherein
the second semiconductor layer (211) is formed by FZ (Floating Zone) method, and
the first semiconductor layer (210) and the first main electrode (252) are formed after the second main electrode (252) and the insulated gate electrode (254) is formed on the second semiconductor layer (211).

3. The plasma display apparatus according to claim 2, wherein
the insulated gate electrode includes a plurality of trench type gate electrodes, and
a semiconductor region (217) of floating of the first conductive type (p) is provided between the trench type gate electrodes to facilitate a conductivity modulation of the IGBT.
